(19) Europäisches Patentamt
European Patent Office
Office européen des brevets

(11) **EP 1 988 402 A2**

(12) **EUROPÄISCHE PATENTANMELDUNG**

(43) Veröffentlichungstag:
**05.11.2008  Patentblatt 2008/45**

(51) Int Cl.:
***G01R 21/06*** *(2006.01)*

(21) Anmeldenummer: **08007692.0**

(22) Anmeldetag: **19.04.2008**

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**
Benannte Erstreckungsstaaten:
**AL BA MK RS**

(30) Priorität: **03.05.2007   DE 102007021079**

(71) Anmelder: **Voith Patent GmbH**
**89522 Heidenheim (DE)**

(72) Erfinder:
 • **Lange, Andreas Dr.**
  **89551 Zang (DE)**
 • **Hoffmann, Rolf Dr.**
  **89555 Steinheim (DE)**
 • **Weber, Volker**
  **89520 Heidenheim (DE)**
 • **Läng, Bernhard**
  **8575 Buerglen/TG (CH)**

(74) Vertreter: **Dr. Weitzel & Partner**
 **Friedenstrasse 10**
 **89522 Heidenheim (DE)**

(54)    **Verfahren zur Bestimmung von Arbeit/Leistung**

(57)    Die Erfindung betrifft ein Verfahren zur Bestimmung der elektrischen Arbeit in Systemen, in denen die Spannung (U) geschaltet wird. Zu vorgegebenen Zeitpunkten ($t_i$) werden dazu Stromwerte (i) gemessen und es wird zwischen den Messungen interpoliert. Anhand der geschalteten Spannung wird eine Klassifizierung jedes interpolierten Stromverlaufs vorgenommen. Der interpolierte Stromverlauf wird dann zwischen den vorgegebenen Zeitpunkten jeweils mit dem/den Spannungswerten zur Leistungsbestimmung multipliziert beziehungsweise integriert. Neben der elektrischen Arbeit kann außerdem gemäß einem weiteren Verfahren analog die elektrische Leistung in derartigen Systemen bestimmt werden.

Fig. 1

EP 1 988 402 A2

**Beschreibung**

Die Erfindung betrifft ein Verfahren zur Bestimmung der elektrischen Arbeit in Systemen, in denen die Spannung geschaltet wird. Außerdem betrifft die Erfindung ein Verfahren zur Bestimmung der elektrischen Leistung in Systemen, in denen die Spannung geschaltet wird.

Bei umrichtergespeisten elektrischen Systemen, insbesondere elektrischen Motoren oder induktiven Bauteilen, wie zum Beispiel Übertragern, Drosseln oder dergleichen, wird die erforderliche Klemmenspannung typischerweise durch anlegen einen getaktet geschalteten Gleichspannung aufgebaut. Damit dies möglichst verlustarm geschehen kann, werden schnelle Schaltvorgänge angestrebt. Um zum Beispiel eine sinusförmige Spannungsform zu erhalten, werden im Rahmen einer Pulsweitenmodulation Spannungszeitblöcke beziehungsweise -pulse verschiedener Zeitdauer angelegt. Schaltregler oder Pulsbreitenmodulatoren sind dabei gängige Mittel zur Erzeugung der Spannungspulse.

Zur Leistungsbestimmung beziehungsweise -messung in derartigen Systemen mit geschalteten Spannungen ist es bisher notwendig, exakt zeitgleich Strom und Spannung zu messen. Insbesondere aufgrund der typischerweise sehr schnell gepulsten Spannungen ist dies mit einem extrem großen technischen Aufwand verbunden. Neben dem erforderlichen Bauraum und dem Gewicht derartiger Hardware, stellen auch die extrem hohen Kosten einen gravierenden Nachteil dar.

Es ist daher die Aufgabe der Erfindung, ein Verfahren anzugeben, bei welchem die oben genannten Nachteile vermieden werden können, und bei welchem es möglich ist, die Arbeit beziehungsweise die Leistung einfach und effektiv mit hoher Genauigkeit zu ermitteln.

Erfindungsgemäß wird diese Aufgabe bezüglich der Arbeit durch die im kennzeichnenden Teil von Anspruch 1 genannten Merkmale gelöst. Eine auf die Leistung bezogene Lösung ergibt sich aus Anspruch 12.

Beim erfindungsgemäßen Verfahren werden zu vorgegebenen Zeitpunkten, welche typischerweise asynchron zu den Zeitpunkten liegen an denen die Spannung geschaltet wird, Stromwerte gemessen. Anschließend werden die Stromwerte zwischen den Messungen interpoliert. Anhand der geschalteten Spannung wird ferner eine Klassifizierung jedes interpolierten Stromverlaufs vorgenommen. Der interpolierte Stromverlauf wird dann mit dem/den Spannungswerten zwischen den vorgegebenen Zeitpunkten jeweils zur Bestimmung der Arbeit im jeweiligen Zeitintervall multipliziert beziehungsweise integriert. Bei bekannter Intervalllänge kann daraus gemäß einer Weiterbildung der Erfindung einfach und schnell die Leistung im jeweiligen Intervall bestimmt werden.

Im Falle eines Spannungspulsmusters mit variabler oder unbekannter Periodendauer, zum Beispiel bei einem Strom-Hystereseregler, ist es nicht möglich, zwischen den gemessenen Stromwerten einen exakten Zeitverlauf anzugeben, da der Stromverlauf infolge von Schalthandlungen Knicke aufweisen kann. Der Stromverlauf wird daher gemäß der Erfindung durch eine Interpolation von Wert zu Wert angenähert. Dabei können mehrere verschieden Fälle auftreten, in welche die interpolierten Stromverläufe klassifiziert werden. Eine derartige Klasse kann zum Beispiel durch die Schaltabfolge der Spannung von 0 zur Zwischenkreisspannung $U_{ZK}$ definiert sein; eine andere durch die Schaltabfolge $+U_{ZK}$, 0, $-U_{ZK}$, USW.

Bei bekannten oder gemessenen Schaltzeitpunkten und Spannungen liegen zu dem interpolierten Verlauf Stromes nun auch die aus den Schaltzeitpunkten und der Zwischenkreisspannung bekannten (oder leicht zu messenden) Spannungsblöcke vor, die nun zeitrichtig den jeweiligen genäherten Strom-Zeitverläufen zugeordnet werden können. Je nach Klasse ergibt sich dann ein jeweils unterschiedlicher Spannungsverlauf und damit eine unterschiedliche Berechung der einzelnen Arbeits- beziehungsweise Leistungswerte.

Anstelle von exakt zeitgleich gewonnenen Messwerten für Strom und Spannung können gemäß der Erfindung nicht - oder allenfalls durch gelegentliches zufälliges Übereinstimmen der Mess- und Schaltzeitpunkte - zeitgleich gemessene Spannungs- und Stromwerte und Näherungen des dazwischen liegenden Stromverlaufs zur Bestimmung der elektrischen Arbeit herangezogen werden.

Entsprechend einer sehr günstigen und vorteilhaften Weiterbildung der Erfindung kann durch Bezugnahme auf die Zeitdauer zwischen den einzelnen Strommessungen aus der Arbeit schnell und einfach die Leistung ermittelt werden.

Es hat sich gezeigt, dass eine Bestimmung der Arbeit beziehungsweise Leistung gemäß der Erfindung schnell und effizient ist und dabei hohe Genauigkeiten liefert. So konnten mit einer einfachen linearen Interpolation und den asynchron zu den Schaltpunkten der Spannung liegenden Strommessungen in dem erfindungsgemäßen Verfahren Arbeitswerte beziehungsweise Leistungswerte ermittelt werden, welche um deutlich weniger als 2 % von mit herkömmlichen Verfahren aufwändig gemessenen Vergleichswerten abwichen. Der Mess- und Rechenaufwand ist dabei gering, so dass die Ermittlung der Arbeit beziehungsweise der Leistung leicht in die Steuerung eines Umrichters integriert und in Echtzeit berechnet werden kann.

Dieses Verfahren eignet sich insbesondere auch zur Leistungsberechnung in der Steuerung eines Frequenzumrichters, zum Beispiel für den Motor eines Fahrantriebes.

In einer besonders günstigen Ausgestaltung des erfindungsgemäßen Verfahrens werden die vorgegebenen Zeitpunkte zur Strommessung in fest vorgegebenem Zeitabstand getaktet.

Die so entstehenden Intervalle zur Strommessung können dann besonders einfach und günstig anhand der Taktung des für das Verfahren genutzten Rechners vorgegeben werden. Die Taktlänge kann dabei dann auch sehr einfach zur Leistungsermittlung aus den Arbeitswerten genutzt werden, indem die Arbeit im jeweiligen Intervall durch die Intervalldauer geteilt wird.

Die Abtastfrequenz des Stromes sollte größer als die Schaltfrequenz sein.

Gemäß einer einfachen und besonders effizienten Variante der Erfindung erfolgt die Interpolation des Stromverlaufs zwischen den gemessenen Werten linear.

Diese einfachste und schnellste aller Näherungsmethoden liefert bereits sehr gute Werte. Die lineare Näherung liefert Strom-Zeit Trapeze, die einfach mit den Spannungs-Zeit-Blöcken multipliziert werden können, um die Arbeit im Intervall zu gewinnen. Auf eine Integration und den damit verbundenen Rechenaufwand kann hier verzichtet werden.

In einer alternativen Ausgestaltung des Verfahrens erfolgt die Interpolation des Stromverlaufs zwischen den gemessenen Werten mit einem Näherungspolynom, insbesondere einem Näherungspolynom 3. Ordnung.

Mit einer solchen Näherung über ein Polynom, auch Spline genannt, kann mit vertretbarem Mehraufwand an Rechenleistung eine weitere Verbesserung der Genauigkeit der ermittelten Arbeits- beziehungsweise Leistungswerte erzielt werden. Obwohl der Spline durchgehend und insbesondere auch in den Messpunkten stetig verläuft wogegen der reale Stromverlauf dagegen Knicke aufweist, kann trotz der mathematisch nicht korrekten Nachbildung des Stromverhaltens eine sehr hohe Genauigkeit der angenäherten Stromwerte und damit auch der integrierten Arbeitswerte und somit letztlich der Leistung erreicht werden.

Weitere vorteilhafte Ausgestaltungen ergeben sich auch den restlichen Unteransprüchen und aus den Ausführungsbeispielen, welche nachfolgend anhand der Figuren beispielhaft erläutert werden.

Dabei zeigen:

Figur 1     Diagramme mit zeitlichem Verlauf von Strom und Spannung;

Figur 2     Diagramme mit zeitlichem mit Strom, Spannung und Leistungsverlauf gemäß einem ersten Fall der Klassifizierung;

Figur 3     Diagramme mit zeitlichem mit Strom, Spannung und Leistungsverlauf gemäß einem zweiten Fall der Klassifizierung;

Figur 4     Diagramme mit zeitlichem mit Strom, Spannung und Leistungsverlauf gemäß einem dritten Fall der Klassifizierung;

Figur 5     Diagramme mit zeitlichem mit Strom, Spannung und Leistungsverlauf gemäß einem vierten Fall der Klassifizierung;

Figur 6     Diagramme mit zeitlichem mit Strom, Spannung und Leistungsverlauf gemäß einem fünften Fall der Klassifizierung;

Figur 7     Diagramme mit zeitlichem mit Strom, Spannung und Leistungsverlauf gemäß einem sechsten Fall der Klassifizierung;

Figur 8     Diagramme mit zeitlichem mit Strom, Spannung und Leistungsverlauf gemäß einem ersten Kombinationsfall von Klassifizierungen;

Figur 9     Diagramme mit zeitlichem Strom, Spannung und Leistungsverlauf gemäß einem zweiten Kombinationsfall von Klassifizierungen; und

Figur 10    Diagramme mit zeitlichem Strom, Spannung und Leistungsverlauf gemäß einem dritten Kombinationsfall von Klassifizierungen.

Die nachfolgenden Beispiele erläutern das erfindungsgemäße Verfahren anhand aller Klassifizierungsfälle. Dabei dient als Beispiel im Wesentlichen die lineare Interpolation. Außerdem werden lediglich die Beträge der Spannungen betrachtet. Eine entsprechende Anwendung auf andere Interpolationsmethoden und positive/negative Spannungswerte kann jedoch in Analogie leicht abgeleitet werden.

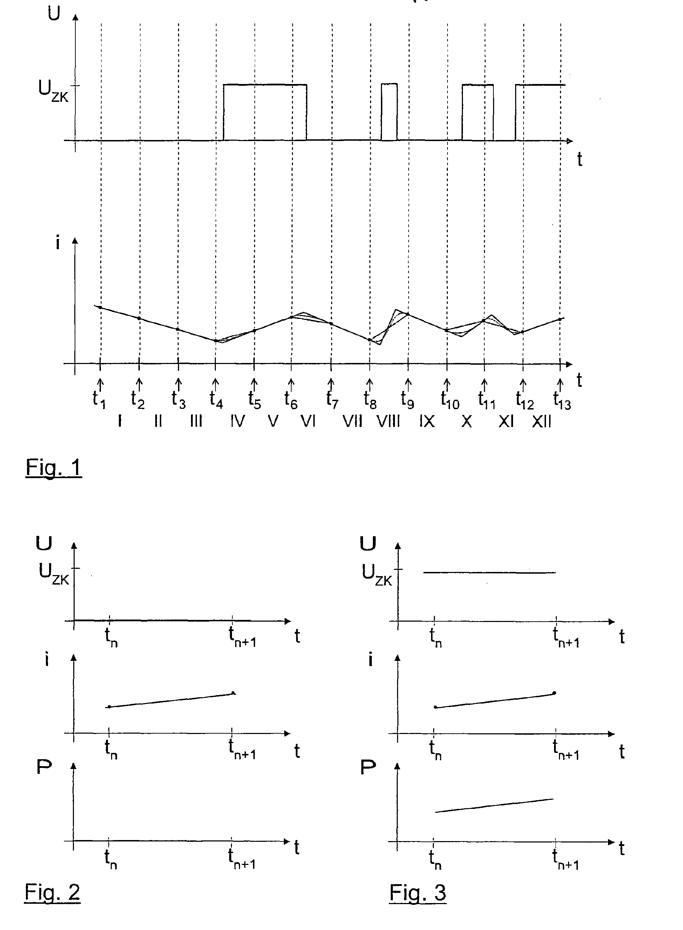

Figur 1 zeigt in zwei Diagrammen mit durchgezogenen Linien den zeitlichen Verlauf einer geschalteten Spannung U(t) und eines Stroms i(t), wie er zum Beispiel durch einen analogen Stromregler erzeugt wird. Es ist erkennbar, dass die Schalthandlungen von Spannung U und die Messungen des Stromes i nicht synchron erfolgen. Bisher mussten zu den Zeitpunkten der Strommessung auch die Spannungen gemessen werden.

Entsprechend dem hier erläuterten Verfahren, erfolgt nun nur noch die Messung des Stroms i(t) an dreizehn diskreten Zeitpunkten $t_1$ bis $t_{13}$, welche zum Beispiel durch die Taktfrequenz eines Rechners vorgegeben werden können. Im hier vorliegenden Fall bilden diese Zeitpunkte zwölf Intervalle, welche hier mit römischen Ziffern von I bis XII nummeriert sind. Der Verlauf des Stromes i(t) wird jeweils durch eine lineare Interpolation zwischen den einzelnen Messpunkten $t_1$ bis $t_{13}$ angenähert. Beim hier mit der durchgezogenen Linie vorgegebenen realen Stromverlauf kommt es dabei in den Intervallen IV, VI, VIII, X und XI zu Abweichungen des linear Interpolierten Stromverlaufs, welcher hier gestrichelt dargestellt ist, vom realen durchgezogen dargestellten Stromverlauf i(t).

Um die oben dargelegte Alternative mit einer Näherung durch einen Spline zu verdeutlichen ist außerdem eine solche Näherung mit punktierten Linien dargestellt. Auch sie weicht nur den oben genannten Intervallen IV, VI, VIII, X und XI vom realen Verlauf ab.

In den Diagrammen der Figur 1 wird nun erkennbar, dass es typischerweise sechs verschiedenen Fälle/Klassifizierungen zu unterscheiden gilt. Diese kann man insbesondere an der Spannung U beziehungsweise deren Schaltverhalten festmachen. Im Idealfall, zum Beispiel bei einem Pulsweitenmodulierten Spannungssignal, sind dabei der jeweilige Schaltzeitpunkt sowie der Betrag $U_{ZK}$ der Zwischenkreisspannung bekannt. Erforderlichenfalls können diese Werte jedoch auch durch eine vergleichsweise einfache weitere Messung ermittelt werden.

Dabei steht in den nachfolgenden Erläuterungen jeweils die Ermittlung der im Intervall geleisteten Arbeit $W_n$ im Vordergrund. Aus dieser kann jedoch durch einfaches beziehen auf die Intervalllänge die Leistung im Intervall ermittelt werden. Auch wäre des denkbar die Arbeit (oder auch die Leistung direkt) über mehrere Intervalle aufzusummieren und dann durch die zeitliche Länge der summierten Intervalle zu teilen.

Eine erste Klasse, wie sie in Figur 2 dargestellt ist, kennzeichnet sich durch das fehlen einer Spannung, also durch den Spannungswert 0. Auch die Arbeit $W_n$ - und damit hier auch die Leistung selbst - im jeweiligen Zeitinterfall dieser Klasse lässt sich einfach mit:

$$W_n = 0 \qquad\qquad (1)$$

bestimmen.

Eine zweite Klasse, wie sie in Figur 3 dargestellt ist, kennzeichnet sich durch das vorhanden sein einer konstanten Spannung $U_{ZK}$. Hier lässt sich die Arbeit $W_n$ im Intervall als Fläche unter der Leistungskurve einfach aus einem Trapez ermitteln, welches die volle Breite des Intervalls aufweist:

$$W_n = \tfrac{1}{2} \cdot (( i(t_n) + i(t_{n+1})) \cdot ( \pm U_{ZK} ) \cdot ( t_{n+1}-t_n ) \qquad\qquad (2)$$

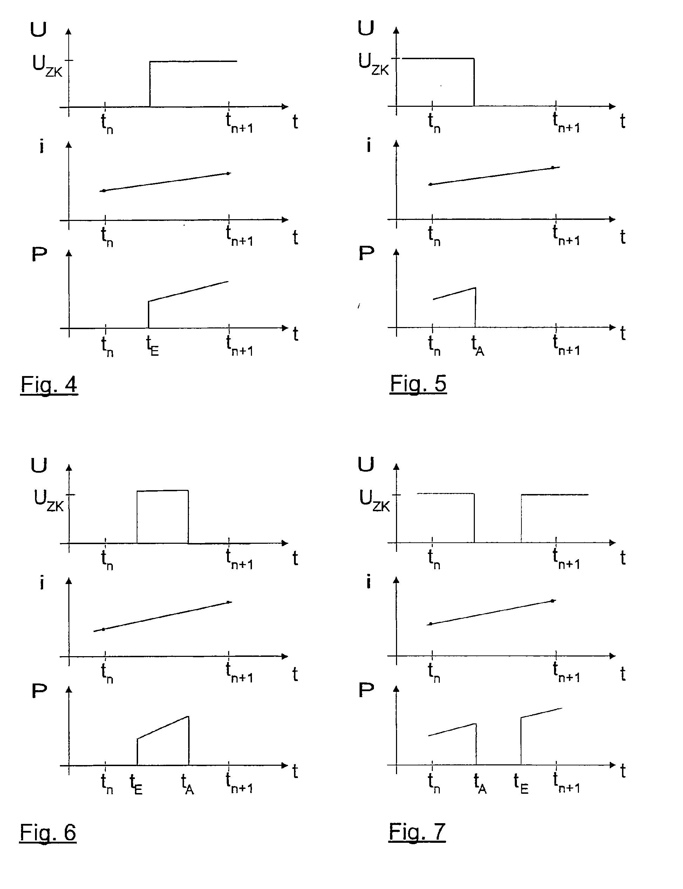

Eine dritte Klasse, wie sie in Figur 4 dargestellt ist, kennzeichnet sich durch ein Einschalten der Spannung zum Zeitpunkt $t_E$ von einem Wert 0 auf die Zwischenkreisspannung $U_{ZK}$ im Intervall. Die Arbeit $W_n$ ermittelt sich hier ebenfalls durch ein Trapez, welches jedoch nur einen Teil der Breite des Intervalls umfasst:

$$W_n = \tfrac{1}{2} \cdot (( i(t_E) + i(t_{n+1})) \cdot ( \pm U_{ZK} ) \cdot ( t_{n+1}-t_E ) \qquad\qquad (3)$$

mit:

$$i(t_E) = i(t_n) + ( i(t_{n+1}) - i(t_n) ) \cdot (( t_E-t_n )/( t_{n+1}-t_n ) \qquad\qquad (3')$$

Eine vierte Klasse, wie sie in Figur 5 dargestellt ist, kennzeichnet sich durch ein Ausschalten der Spannung zum Zeitpunkt $t_A$ von der Zwischenkreisspannung $U_{ZK}$ auf einen Wert 0 im Intervall. Die Arbeit $W_n$ ermittelt sich hier ebenfalls durch ein Trapez, welches nur einen Teil der Breite des Intervalls umfasst:

$$W_n = \tfrac{1}{2} \cdot (( \, i(t_A) + i(t_n)) \cdot ( \pm U_{ZK} ) \cdot ( \, t_A - t_n ) \qquad (4)$$

mit:

$$i(t_A) = i(t_n) + ( \, i(t_{n+1}) - i(t_n) \, ) \cdot (( \, t_A - t_n \, )/( \, t_{n+1} - t_n \, ) \qquad (4')$$

Eine fünfte Klasse, wie sie in Figur 6 dargestellt ist, kennzeichnet sich durch eine Abfolge von zwei Schaltungen im Intervall. Dabei erfolgt zuerst ein Einschalten der Spannung zum Zeitpunkt $t_E$ von einem Wert 0 auf die Zwischenkreisspannung $U_{ZK}$ und anschließend ein Ausschalten der Spannung zum Zeitpunkt $t_A$ von der Zwischenkreisspannung $U_{ZK}$ auf einen Wert 0. Die Arbeit $W_n$ ermittelt sich hier ebenfalls durch ein Trapez, welches nur einen Teil der Breite des Intervalls umfasst:

$$W_n = \tfrac{1}{2} \cdot (( \, i(t_A) + i(t_E)) \cdot ( \pm U_{ZK} ) \cdot ( \, t_A - t_E ) \qquad (5)$$

mit:

$$i(t_A) = i(t_n) + ( \, i(t_{n+1}) - i(t_n) \, ) \cdot (( \, t_A - t_n \, )/( \, t_{n+1} - t_n \, ) \qquad (5')$$

und:

$$i(t_E) = i(t_n) + ( \, i(t_{n+1}) - i(t_n) \, ) \cdot (( \, t_E - t_n \, )/( \, t_{n+1} - t_n \, ) \qquad (5'')$$

Eine sechste und letzte mögliche Klasse, wie sie in Figur 7 dargestellt ist, kennzeichnet sich ebenfalls durch eine Abfolge von zwei Schaltungen. Diese erfolgen jedoch in umgekehrter Reihenfolge wie in der vorhergehenden Klasse. Es erfolgt also zuerst ein Ausschalten der Spannung zum Zeitpunkt $t_A$ von der Zwischenkreisspannung $U_{ZK}$ auf einen Wert 0, dann ein Einschalten der Spannung zum Zeitpunkt $t_E$ von dem Wert 0 auf die Zwischenkreisspannung $U_{ZK}$. Die Arbeit $W_n$ ermittelt sich hier durch zwei Trapeze, welche jeweils einzeln und in der Summe nur einen Teil der Breite des Intervalls umfassen:

$$\begin{aligned} W_n = \ & \tfrac{1}{2} \cdot (( \, i(t_n) + i(t_A)) \cdot ( \pm U_{ZK} ) \cdot ( \, t_A - t_n \, ) \\ & + \tfrac{1}{2} \cdot (( \, i(t_E) + i(t_{n+1})) \cdot ( \pm U_{ZK} ) \cdot ( \, t_{n+1} - t_E \, ) \qquad (6) \end{aligned}$$

mit:

$$i(t_A) = i(t_n) + ( \, i(t_{n+1}) - i(t_n) \, ) \cdot (( \, t_A - t_n \, )/( \, t_{n+1} - t_n \, ) \qquad (6')$$

und:

$$i(t_E) = i(t_n) + ( \, i(t_{n+1}) - i(t_n) \, ) \cdot (( \, t_E - t_n \, )/( \, t_{n+1} - t_n \, ) \qquad (6'')$$

Die hier beispielhaft jeweils positive dargestellte Steigung des Stromverläufe kann selbstverständlich in den einzelnen Intervallen real sowohl positiv als auch negativ ausfallen. Verwendet man anstelle der linearen Interpolation zum Beispiel einen Spline, so muss zur Ermittlung der Arbeit $W_n$ die Fläche unter der interpolierten Leistungskurve jeder der Klassen etwas aufwändiger Integriert werden.

Ferner lassen sich die sechs Klassen auch auf drei verallgemeinerte Klassen reduzieren. Dafür recht es aus, die drei neuen Klassen über die Zahl der im Intervall stattfindenden Schalthandlungen zu klassifizieren. Zusätzlich benötigt man dann einen Faktor k, welcher je nach Schaltzustand die Werte

$$k = -1; 0 ; +1$$

annimmt. Anstelle des "echten" vorzeichenbehafteten Werts der Ausgangsspannung $U_A$, was oben durch das Formelzeichen $\pm U_{ZK}$ angedeutet ist, reicht hier - aufgrund des vorzeichenbehafteten Werts k - der Betrag der Zwischenkreisspannung $|U_{ZK}|$ zur Berechung aus.

Folgt man diesem Ansatz so erhält man drei Formeln, um im jeweiligen Intervall für alle denkbaren Klassen die Arbeit $W_n$ zu bestimmen.

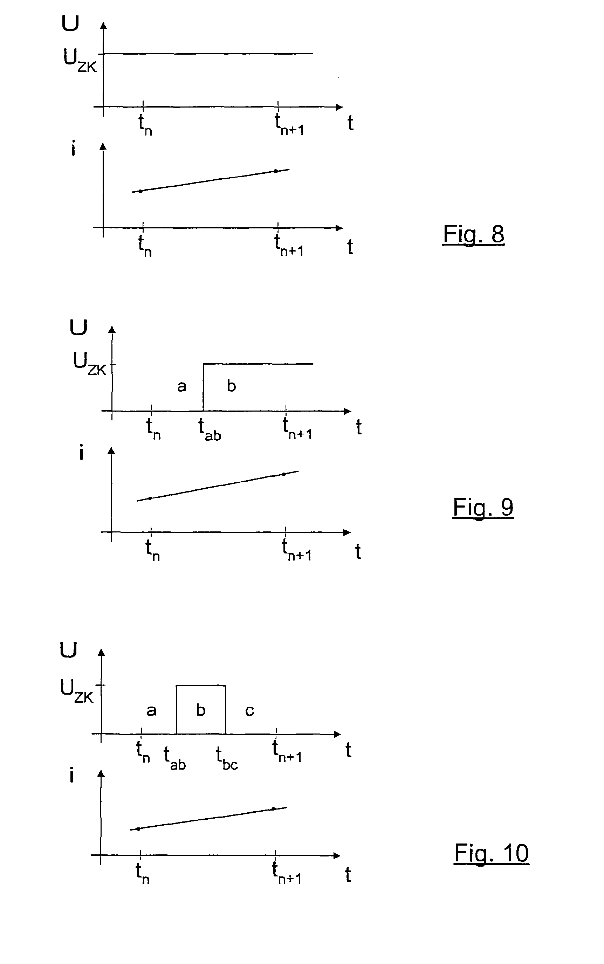

Die erste Klasse, wie sie in Figur 8 zu erkennen ist, definiert sich dadurch, dass keine Schalthandlung erfolgt. Die Arbeit $W_n$ (in den Figuren 8-10 nicht mehr explizit dargestellt) ermittelt sich analog den oben gemachten Ausführungen als einfaches Trapez über die gesamte Breite des Intervalls durch:

$$W_n = \tfrac{1}{2} \cdot (( i(t_n) + i(t_{n+1})) \cdot |U_{ZK}| \cdot ( t_{n+1}-t_n ) \cdot k \qquad\qquad (A)$$

Mit k = -1; 0 ; +1, je nach Zustand der Spannung.

Die zweite Klasse, wie sie in Figur 9 zu erkennen ist, definiert sich durch eine Schalthandlung (a → b). Die Arbeit $W_n$ ermittelt sich als Summe der Trapeze über die Teile der Intervallbreite durch:

$$W_n \;\; = \tfrac{1}{2} \cdot (( i(t_n) + i(t_{ab})) \cdot |U_{ZK}| \cdot ( t_{ab}-t_n ) \cdot k_a$$
$$+ \tfrac{1}{2} \cdot (( i(t_{ab}) + i(t_{n+1})) \cdot |U_{ZK}| \cdot ( t_{n+1} - t_{ab} ) \cdot k_b \qquad\qquad (B)$$

mit:

$$i(t_{ab}) = i(t_n) + ( i(t_{n+1}) - i(t_n) ) \cdot (( t_{ab}-t_n )/( t_{n+1}-t_n ) \qquad\qquad (B')$$

und mit $k_a, k_b$ = -1;0;+1 je nach Zustand der Spannung im jeweiligen Teilabschnitt des Intervalls.

Die dritte Klasse, wie sie in Figur 10 zu erkennen ist, definiert sich durch zwei Schalthandlung (a → b → c). Die Arbeit $W_n$ ermittelt sich als Summe der Trapeze über die Teile der Intervallbreite durch:

$$W_n \;\; = \tfrac{1}{2} \cdot (( i(t_n) + i(t_{ab})) \cdot |U_{ZK}| \cdot ( t_{ab}-t_n ) \cdot k_a$$
$$+ \tfrac{1}{2} \cdot (( i(t_{bc}) + i(t_{ab})) \cdot |U_{ZK}| \cdot ( t_{bc}-t_{ab} ) \cdot k_b$$
$$+ \tfrac{1}{2} \cdot (( i(t_{n+1}) + i(t_{ab})) \cdot |U_{ZK}| \cdot ( t_{n+1}-t_{bc} ) \cdot k_c \qquad\qquad (C)$$

mit:

$$i(t_{ab}) = i(t_n) + ( i(t_{n+1}) - i(t_n) ) \cdot (( t_{ab}-t_n )/( t_{n+1}-t_n ) \qquad\qquad (C')$$

und:

$$i(t_{bc}) = i(t_n) + ( i(t_{n+1}) - i(t_n) ) \cdot (( t_{bc}-t_n )/( t_{n+1}-t_n ) \qquad (C'')$$

und mit $k_a, k_b, k_c = -1 ; 0; +1$ je nach Zustand der Spannung im jeweiligen Teilabschnitt des Intervalls.

Die Leistung selbst kann wie oben bereits erwähnt aus der ermittelten Arbeit durch beziehen auf die Intervalllänge (teilen des Arbeitswerts im jeweiligen Intervall durch die Intervalldauer) leicht ermittelt werden. Durch die Reduzierung der Fallzahl gemäß den zweiten Beispiel (Formeln A-C) kann eine einfachere und schnellere Klassifizierung erreicht werden. Damit lässt sich auch die Leistungsbestimmung schneller und besser realisieren. Einen vergleichbaren Ansatz kann man hier natürlich auch mit einem Spline anstelle der linearen Interpolation verwenden, anstelle der Trapeze sind dann eben anders geformte Flächen im jeweiligen Interfall zu integrieren und mit der Spannung und dem Werte k zu multiplizieren.

Mit beiden erläuterten Verfahren kann die Leistung in den jeweiligen Intervallen sehr einfach und mit ausreichend hoher Genauigkeit ermittelt und bei Bedarf - direkt oder als Arbeit mit anschließender Teilung durch die Summe der Zeiten - über mehrere Intervalle aufsummiert werden, um diese zum Beispiel als Basis für Leistungsgeregelte Verfahren oder dergleichen zu nutzen.

**Patentansprüche**

1. Verfahren zur Bestimmung der elektrischen Arbeit in Systemen, in denen die Spannung geschaltet wird, **dadurch gekennzeichnet, dass**

   1.1 zu vorgegebenen Zeitpunkten Stromwerte gemessen werden,
   1.2 die Stromwerte zwischen den Messungen interpoliert werden,
   1.3 anhand der geschalteten Spannung eine Klassifizierung jedes interpolierten Stromverlaufs vorgenommen wird; und
   1.4 der interpolierte Stromverlauf zwischen den vorgegebenen Zeitpunkten jeweils mit dem/den Spannungswerten zur Leistungsbestimmung multipliziert beziehungsweise integriert.

2. Verfahren nach Anspruch 1, **dadurch gekennzeichnet, dass** die Spannung zu unregelmäßigen Zeitpunkten zwischen diskreten Werten geschaltet wird.

3. Verfahren nach Anspruch 2, **dadurch gekennzeichnet, dass** die Spannung zwischen Null und einem positiven sowie einem negativen Wert des selben Betrags geschaltet wird.

4. Verfahren nach einem der Ansprüche 1 bis 3,
   **dadurch gekennzeichnet,**
   **dass** die Schaltzeitpunkte und Werte der Spannung gemessen werden.

5. Verfahren nach einem der Ansprüche 1 bis 4, **dadurch gekennzeichnet, dass** die Schaltzeitpunkte und Werte der aus der Steuerung des Systems, insbesondere der pulsweitenmodulierten Steuerung, bekannt sind.

6. Verfahren nach einem der Ansprüche 1 bis 5, **dadurch gekennzeichnet, dass** die vorgegebenen Zeitpunkte zur Strommessung in fest vorgegebenem Zeitabstand getaktet werden.

7. Verfahren nach einem der Ansprüche 1 bis 6, **dadurch gekennzeichnet, dass** die Interpolation des Stromverlaufs zwischen den gemessenen Werten linear erfolgt.

8. Verfahren nach einem der Ansprüche 1 bis 6, **dadurch gekennzeichnet, dass** die Interpolation des Stromverlaufs zwischen den gemessenen Werten mit einem Näherungspolynom erfolgt.

9. Verfahren nach Anspruch 8, **dadurch gekennzeichnet, dass** eine Näherungspolynom dritter Ordnung verwendet wird.

10. Verfahren nach einem der Ansprüche 1 bis 9, **dadurch gekennzeichnet, dass** die Klassifizierung jeweils anhand der Zahl und/oder Richtung der Schaltvorgänge der Spannung zwischen den gemessenen Stromwerten erfolgt.

11. Verfahren nach einem der vorhergegangen Ansprüche, **dadurch gekennzeichnet, dass** die Bestimmung der Arbeit über einen getakteten Rechner erfolgt.

12. Verfahren zur Bestimmung der elektrischen Leistung in Systemen, in denen die Spannung geschaltet wird, **dadurch gekennzeichnet, dass** zuerst die elektrische Arbeit nach einem der oben genannten Ansprüche ermittelt wird und daraus durch Bezug auf den Zeitraum zwischen den Messungen die Leistung bestimmt wird.

Fig. 1

Fig. 2

Fig. 3

Fig. 4

Fig. 5

Fig. 6

Fig. 7

Fig. 8

Fig. 9

Fig. 10